# EUROPÄISCHE PATENTSCHRIFT

(11) **EP 3 176 920 B1**
(45) Veröffentlichungstag und Bekanntmachung des Hinweises auf die Patenterteilung: **03.08.2022**
(21) Anmeldenummer: 16200878.3
(22) Anmeldetag: 28.11.2016
(51) Int. Cl.: H02K 7/14, H02K 11/33, H02K 9/02

(54) **ABDECKVORRICHTUNG FÜR EIN ELEKTRONIKGEHÄUSE EINES ELEKTROMOTORS**
COVERING DEVICE FOR AN ELECTRONICS ENCLOSURE OF AN ELECTRIC MOTOR
DISPOSITIF DE COUVERCLE POUR UN BOÎTIER ÉLECTRONIQUE D'UN MOTEUR ÉLECTRIQUE

(30) Priorität: 04.12.2015 DE 102015121166
(43) Veröffentlichungstag der Anmeldung: 07.06.2017
(73) Patentinhaber: ebm-papst Mulfingen GmbH & Co. KG, 74673 Mulfingen (DE)
(72) Erfinder: STURM, Michael, 97980 Bad Mergentheim-Rot (DE); SAUER, Thomas, 97980 Bad Mergentheim (DE)
(74) Vertreter: Staeger & Sperling Partnerschaftsgesellschaft mbB

(56) Entgegenhaltungen:
- DE-A1- 10 313 273
- DE-A1-102009 044 240
- US-A1- 2011 074 235
- US-A1- 2014 325 789

## Beschreibung

Die Erfindung betrifft eine Abdeckvorrichtung für ein Elektronikgehäuse eines Elektromotors. In dem Elektronikgehäuse wird die Motorelektronik aufgenommen, an der sich ein in das Elektronikgehäuse integrierter Kühlluftkanal vorbei erstreckt.

Elektromotoren aus dem Bereich der Erfindung werden insbesondere zum Antrieb von Ventilatoren eingesetzt. Dabei werden sie regelmäßig über die Statorbuchse an Befestigungswänden oder Tragkonstruktionen montiert, wodurch eine effektive Kühlung erschwert wird. Der Leistungsbereich sowie die Lebensdauer des Elektromotors bestimmen sich unter anderem auch nach den im Betrieb erreichten Bauteiltemperaturen, vor allem der integrierten Motorelektronik, elektrischen Leistungsbauteile, Lager und Motorantriebsbauteile. Aus diesem Grund ist eine ausreichende und dauerhafte Kühlung der Bauteile von großer Bedeutung.

Aus dem Stand der Technik, beispielsweise der DE 10 2012 107 109 A1 ist bekannt, über ein Luftförderelement im Motorbetrieb einen axialen Luftvolumenstrom zur aktiven Kühlung der Bauteile, insbesondere der Motorelektronik zu erzeugen, der durch einen Kühlluftkanal im Elektronikgehäuse geführt wird. Der Luftvolumenstrom wird am Elektronikgehäuse zumeist axial angesaugt und radial ausgeblasen. Dabei hat sich im Außeneinsatz gezeigt, dass neben Luft auch Feststoffe wie z.B. Laub und Blätter angesaugt werden, die den Kühlluftkanal verstopfen und die Kühlleistung verringern. Aus dem Stand der Technik bekannte Schutzgitter sind zur Überwindung des Problems ungeeignet, da sie nur eine Ansaugrichtung bereitstellen und somit ebenfalls durch Laub, Blätter oder dergleichen zusetzbar sind. Sie lassen dann keine Kühlluftansaugung mehr zu. Weiterer Stand der Technik ist beispielsweise in den Druckschriften US 2011/074235 A1, DE 103 13 273 A1, DE102013219309 und US 2014/325789 A1 offenbart.

Der Erfindung liegt deshalb die Aufgabe zugrunde, eine variabel einsetzbare Abdeckvorrichtung für einen Elektromotor mit Elektronikgehäuse bereitzustellen, die eine Elektronikgehäuseöffnung zur Ansaugung von Kühlluft gegenüber einem Verstopfen durch Feststoffe schützt. Ferner ist es Aufgabe der Erfindung, einen Elektromotor bereit zu stellen, dessen Kühlung im Außeneinsatz dauerhaft sichergestellt ist.

Diese Aufgabe wird gelöst durch die Merkmalskombination gemäß der Patentansprüche 1 und 8.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine perspektivische Ansicht eines Elektromotors, teilweise in Explosionsdarstellung;
- Fig. 2: den Elektromotor aus Fig. 1 im montierten Zustand;
- Fig. 3: einen Ausschnitt einer seitlichen Schnittansicht des Elektromotors aus Figur 2;
- Fig. 4: eine perspektivische Ansicht eines Elektronikgehäuses, teilweise in Explosionsdarstellung, in einer alternativen Ausführung;
- Fig. 5.: eine perspektivische Ansicht eines Elektromotors, teilweise in Explosionsdarstellung, in einer weiteren alternativen Ausführung;
- Fig. 6: den Elektromotor aus Fig. 5 im montierten Zustand;
- Fig. 7: eine perspektivische Ansicht eines Elektromotors, teilweise in Explosionsdarstellung, in einer weiteren alternativen Ausführung;
- Fig. 8: den Elektromotor aus Fig. 7 im montierten Zustand;

Die Figuren zeigen verschiedene Ausführungsbeispiele der Erfindung, wobei gleiche Bezugszeichen gleiche Teile benennen.

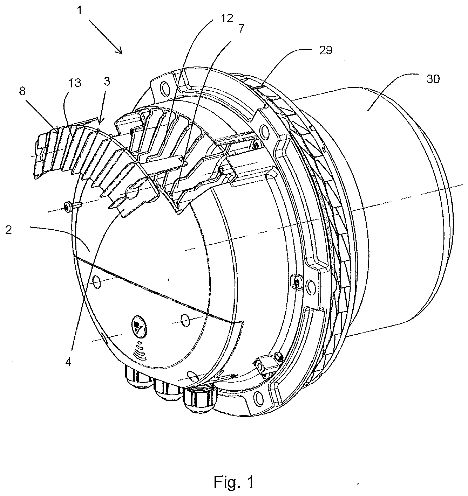

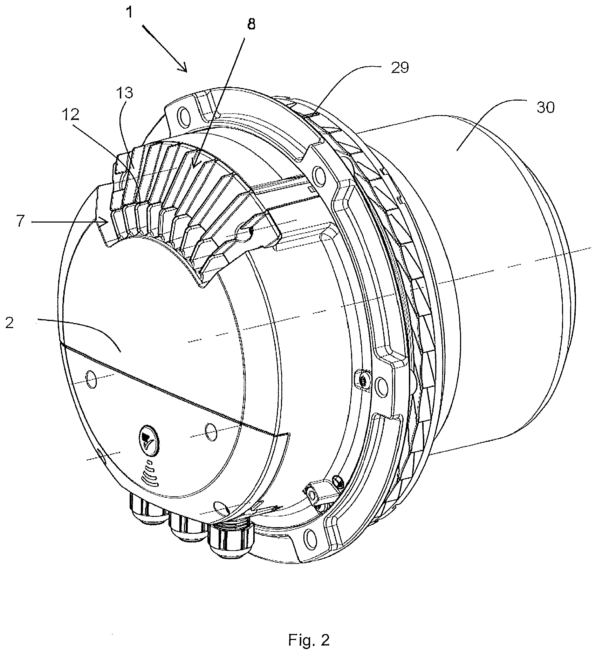

In den Figuren 1 bis 3 ist in einem ersten Ausführungsbeispiel ein Elektromotor 1 mit einem Elektronikgehäuse 2 und einer axial daran angeschlossener Statorbuchse 28 mit Rotor 30 dargestellt. Zwischen dem Elektronikgehäuse 2 und dem Rotor 30 ist ein Laufrad 29 angeordnet, das im Motorbetrieb einen Luftvolumenstrom erzeugt, der zur Kühlung der in dem Elektronikgehäuse 2 aufgenommenen Motorelektronik in axialer Richtung durch den in das Elektronikgehäuse 2 integrierten Kühlluftkanal 6 strömt. Der Kühlluftkanal 6 erstreckt sich bis zu der axialen Elektronikgehäuseöffnung 7 im axialen Endabschnitt des Elektronikgehäuses 2. An dem Elektronikgehäuse 2 wird außenseitig an die axiale Elektronikgehäuseöffnung 7 angrenzend und diese teilweise flächig überdeckend die Abdeckvorrichtung 3 angeordnet. Die Abdeckvorrichtung 3 ist als Ringsegment ausgebildet und weist mehrere geradlinig in radialer Richtung verlaufende Axialrippen 13 auf, die jeweils zwischen sich radiale Strömungskanäle 8 bilden. Die Abdeckvorrichtung 3 ist in Fig. 2 an dem Elektronikgehäuse 2 verschraubt, wobei der radiale

Öffnungsabschnitt 10 der Elektronikgehäuseöffnung 7 mit den radialen Strömungskanälen 8 strömungsverbunden ist. Die

Elektronikgehäuseöffnung 7 des Elektronikgehäuses 2 ist durch die an dem Elektronikgehäuse 2 ausgebildeten Kühlrippen 12 gebildet. Die Kühlrippen 12 sind zueinander in Umfangsrichtung beabstandet und erstrecken sich als flache, ebene Plattenkörper in axialer und radialer Richtung.

Die Abdeckvorrichtung 3 weist als Grundkörper des Ringsegments ein als Bodenplatte ausgebildetes Basissegment 4 auf, auf dessen Oberseite einteilig die sich in radialer Richtung geradlinig erstreckenden Axialrippen 13 ausgebildet sind. Die Abdeckvorrichtung 3 liegt auf axialen Stirnseiten der Kühlrippen 12 des Elektronikgehäuses 2 flächig auf. Die Axialrippen 13 der Abdeckvorrichtung 3 erstrecken sich in radialer Verlängerung fluchtend und aneinander stoßend zu den Kühlrippen 12 des Elektronikgehäuses 2, so dass die Strömungskanäle 8 des Abdeckprofils 3 unmittelbar in die durch die Kühlrippen 12 gebildeten radialen Öffnungsabschnitt 10 der Elektronikgehäuseöffnung 7 übergehen.

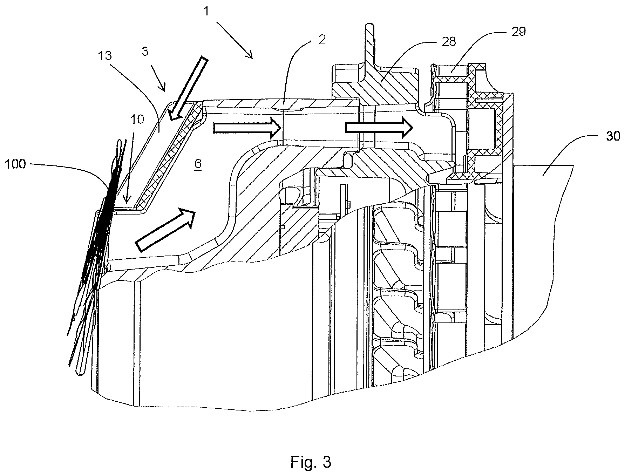

Figur 3 zeigt beispielhaft eine Verschmutzung der axialen Seite des Kanaleingangs 7 der Ausführung gemäß Figur 2 mit Laub 100, so dass die Einströmung des mit Pfeilen dargestellten Luftvolumentstromes in den Kühlluftkanal 6 hauptsächlich aus radialer Richtung durch die Strömungskanäle 8 der Abdeckvorrichtung 3 erfolgt.

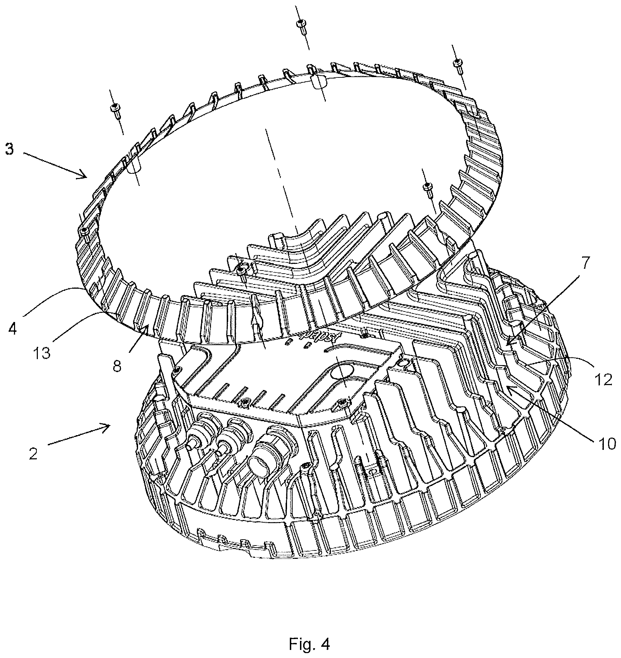

Figur 4 zeigt ein erstes alternatives Ausführungsbeispiel eines Elektronikgehäuses 2 mit Abdeckvorrichtung 3 in Explosionsdarstellung. Die Abdeckvorrichtung 3 entspricht bezüglich seiner Merkmale der Ausführung gemäß Fig. 1, jedoch ist sie im Unterschied zu Fig. 1 als geschlossener Ring ausgebildet, der vollumfänglich auf den Kühlrippen 12 des Elektronikgehäuses 2 zu Auflage gebracht wird. Die Kühlrippen 12 weisen stirnseitig eine komplementäre Form zu dem konisch zulaufend ausgebildeten Basissegment 4 der Abdeckvorrichtung 3 auf. Auch bei dieser Ausführung erstrecken sich die Axialrippen 13 in Verlängerung und parallel zu den Kühlrippen 12 des Elektronikgehäuses 2, so dass die Strömungskanäle 8 des Abdeckprofils 3 unmittelbar in die durch die Kühlrippen 12 gebildeten radialen Öffnungsabschnitt 10 der Elektronikgehäuseöffnung 7 übergehen. Der Kühlluftkanal 6 umgibt bei dieser Ausführung das gesamte Elektronikgehäuse 2 in Umfangsrichtung. Ferner erstrecken sich die Kühlrippen 12 des Elektronikgehäuses 2 in axialer Richtung weiter über die Elektronikgehäuseöffnung 7 hinaus bis zum axialen Endabschnitt des Elektronikgehäuses 2. Sie bilden Vertiefungen auf der Außenfläche des Elektronikgehäuses 2 und vergrößern dadurch die Gesamtkühlungsfläche.

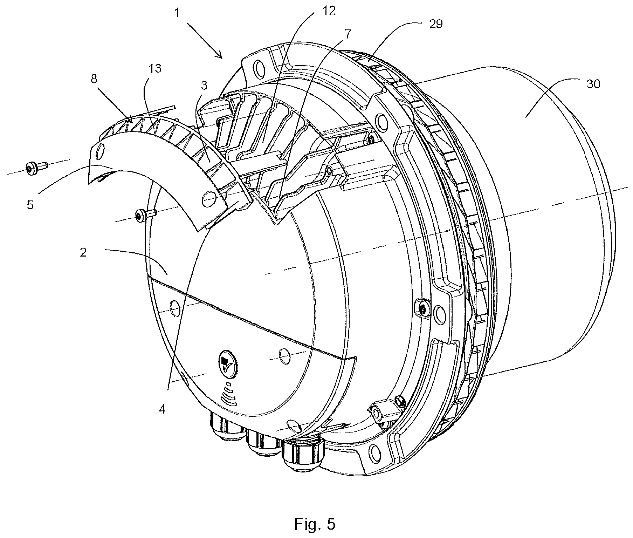

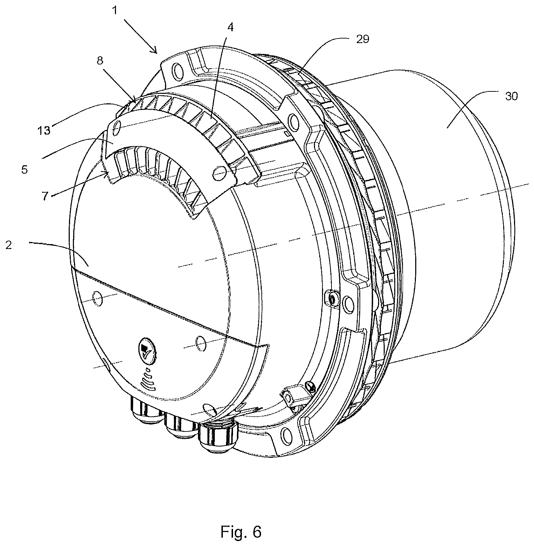

In den Figuren 5 und 6 ist ein weiteres Ausführungsbeispiel des Elektromotors 1 dargestellt, wobei alle nicht die Abdeckvorrichtung 3 betreffenden Merkmale identisch zur Ausführung gemäß der Figuren 1 bis 3 sind und entsprechend auch für diese Ausführung gelten.

Die Abdeckvorrichtung 3 ist ein austauschbares modulares Bauteil und weist zusätzlich zu dem Basissegment 4 das Decksegment 5 auf, wobei sich zwischen dem Basissegment 4 und dem Decksegment 5 die zueinander beabstandeten Axialrippen 13 erstrecken, die jeweils zwischen sich die radialen Strömungskanäle 8 bilden. Die Abdeckvorrichtung 3 gemäß Figur 5 ist ein einteiliges Ringsegment, das an das Elektronikgehäuse 2 geschraubt wird. Das Basissegment 4 weist einen konisch zulaufenden Querschnitt auf, der komplementär zum stirnseitigen Verlauf der Kühlrippen 12 ist. Das Decksegment 5 erstreckt sich in radialer Richtung bis zu der Elektronikgehäuseöffnung 7, der gebildet wird durch die Kühlrippen 12. Gegenüber dem radialen Außenrand des Basissegments 4 ist das Decksegment 5 bezogen auf seinen radialen Außenrand radial einwärts versetzt angeordnet. Die Axialrippen 13 verlaufen mit ihren radialen Außenkanten schräg zwischen dem Basissegment 4 und dem Decksegment 5 und schließen jeweils bündig mit dem radialen Außenrand des Basissegments 4 und dem radialen Außenrand des Decksegments 5 ab. Der Axialabstand zwischen dem Basissegment 4 und dem Decksegment 5 ist konstant. Die Zuströmung erfolgt bei einer Verschmutzung der axialen Seite der Elektronikgehäuseöffnung 7 radial über die Strömungskanäle 8, die gebildet sind zwischen den Axialrippen 13 und dem Deck- und Basissegment 5, 4.

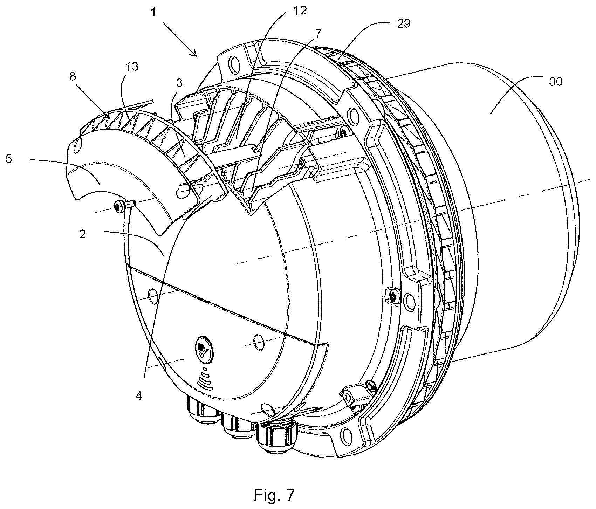

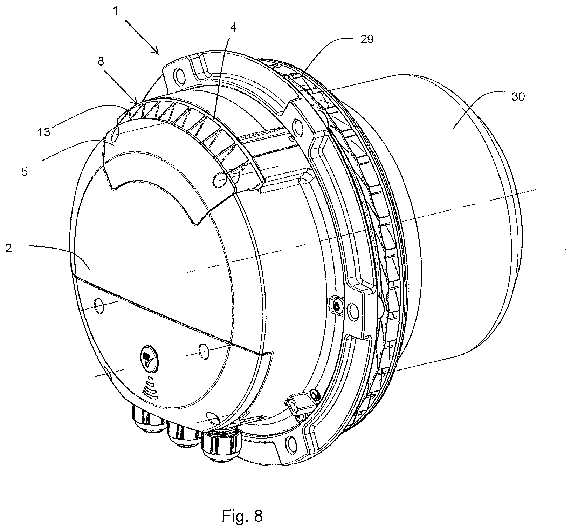

Die Figuren 7 und 8 zeigen ein weiteres Ausführungsbeispiel, das sich gegenüber dem Ausführungsbeispiel aus den Figuren 5 und 6 dadurch unterscheidet, dass das Decksegment 5 der Abdeckvorrichtung 3 die Elektronikgehäuseöffnung 7 und mithin die Kühlrippen 12 in axialer Richtung vollständig überdeckt. Dadurch entsteht eine ausschließlich radiale Einströmrichtung. Deshalb eignet sich die Ausführung für eine Einbaurichtung des Elektromotors in vertikaler Richtung, so dass herabfallendes Laub auf dem Decksegment 5 zur Auflage kommt, jedoch die radialen Strömungskanäle 8 stets offen bleiben. Im Übrigen sind die Merkmale identisch zur Ausführung gemäße Figur 5 und auf die Ausführung gemäß Figur 7 übertragbar.

Die Erfindung beschränkt sich in ihrer Ausführung nicht auf die vorstehend angegebenen bevorzugten Ausführungsbeispiele. Ebenfalls umfasst werden Ausführungen, bei denen eine Abdeckvorrichtung gemäß Figur 5 als vollumfänglicher Ring gemäß Figur 4 ausgebildet und auf Rippen 12 des Elektronikgehäuses 2 über dessen gesamten Umfang aufgelegt wird. Auch können sich die Axialrippen 13 der Abdeckvorrichtung in radialer Richtung über einen radialen Innenrand des Decksegments 5 hinaus radial einwärts erstrecken und an die Rippen 12 des Elektronikgehäuses zur Anlage gebracht werden oder den nach axial außen frei stehend Abschnitt der Kühlrippen 12 ersetzen.

In einer weiteren nicht dargestellten Ausführungsvariante wird die Abdeckvorrichtung mit einer Geometrie gemäß der oben dargestellten Ausführungsbeispiele unmittelbar an dem Elektronikgehäuse 2 angebunden, stoffschlüssig oder einteilig. Beispielhaft hierfür wäre ein komplettes Druckgussteil. In einer alternativen Variante ist die Abdeckvorrichtung aus Kunststoff hergestellt.

## Patentansprüche

1. Abdeckvorrichtung (3) für ein Elektronikgehäuse (2) eines Elektromotors (1) mit zumindest einem Basissegment (4) und mehreren an dem Basissegment (4) ausgebildeten Rippen (13), wobei das Basissegment (4) geometrisch ausgebildet ist, eine Elektronikgehäuseöffnung zur Ansaugung eines Kühlluftvolumenstroms zumindest abschnittsweise zu überdecken, um die Elektronikgehäuseöffnung gegen Eindringen von Feststoffen zumindest abschnittsweise zu verschließen, und die Rippen (13) als Axialrippen ausgebildet sind und mit einer Oberfläche des Basissegments (4) jeweils einen Strömungskanal (8) bilden, der mit der Elektronikgehäuseöffnung strömungsverbindbar ist, **dadurch gekennzeichnet, dass** die Abdeckvorrichtung ringförmig oder teilringförmig ausgebildet ist und die mehreren Rippen (13) schräg nach radial innen verlaufen, so dass sich die Strömungskanäle (8) zwischen den Rippen (13) in Richtung radial einwärts verengen, und wobei die Abdeckvorrichtung als modularer Einsatz für das Elektronikgehäuse (2) ausgebildet ist.

2. Abdeckvorrichtung nach Anspruch 1, **dadurch gekennzeichnet, dass** sie aus einem Basissegment (4) und einem Decksegment (5) gebildet ist, wobei sich die zumindest eine Rippe (13) zwischen dem Basissegment (4) und dem Decksegment (5) erstreckt und durch die zumindest eine Rippe (13), das Basissegment (4) und das Decksegment (5) die Strömungskanäle (8) gebildet sind.

3. Abdeckvorrichtung nach zumindest einem der vorigen Ansprüche, **dadurch gekennzeichnet, dass** zumindest das Basissegment (4) konisch ausgebildet ist.

4. Abdeckvorrichtung nach zumindest einem der vorigen Ansprüche 2 bis 4, **dadurch gekennzeichnet, dass** das Decksegment (5) gegenüber einem radialen Außenrand des Basissegments (4) radial einwärts versetzt angeordnet ist.

5. Abdeckvorrichtung nach dem vorigen Anspruch, **dadurch gekennzeichnet, dass** die Rippen (13) eine radiale Außenkante aufweisen, welche einen radialen Außenrand des Basissegments (4) und einen radialen Außenrand des Decksegments (5) unmittelbar verbindet.

6. Abdeckvorrichtung nach dem vorigen Anspruch, **dadurch gekennzeichnet, dass** die Rippen (13) bündig mit dem radialen Außenrand des Basissegments (4) und/oder bündig mit dem radialen Außenrand des Decksegments (5) abschließen.

7. Abdeckvorrichtung nach zumindest einem der vorigen Ansprüche 2 bis 7, **dadurch gekennzeichnet, dass** sich die Rippen (13) in radialer Richtung über einen radialen Innenrand des Decksegments (5) hinaus radial einwärts erstrecken.

8. Verwendung einer Abdeckvorrichtung (3) nach zumindest einem der vorigen Ansprüche an einem Elektronikgehäuse (2) eines Elektromotors (1).

9. Elektromotor, umfassend ein Elektronikgehäuse (2) mit darin aufgenommener Motorelektronik, wobei das Elektronikgehäuse (2) einen integrierten und sich zumindest in axialer Richtung an der Motorelektronik vorbei erstreckenden Kühlluftkanal (6) aufweist, durch den der Kühlluftvolumenstrom förderbar ist, wobei der Kühlluftkanal (6) an der Elektronikgehäuseöffnung endet, **dadurch gekennzeichnet, dass** auf der Elektronikgehäuseöffnung die Abdeckvorrichtung (3) nach zumindest einem der Ansprüche 1 bis 7 befestigbar ist.

10. Elektromotor nach dem vorigen Anspruch, **dadurch gekennzeichnet, dass** die Elektronikgehäuseöffnung durch Kühlrippen (12) gebildet ist und sich die Rippen (13) der Abdeckvorrichtung (3) parallel und/oder in radialer Verlängerung zu den Kühlrippen (12) des Elektronikgehäuses (2) erstrecken.

11. Elektromotor nach dem vorigen Anspruch, **dadurch gekennzeichnet, dass** die Elektronikgehäuseöffnung einen radialen Öffnungsabschnitt aufweist, der senkrecht zu einer Rotationsachse des Elektromotors ausgerichtet ist, wobei der radiale Öffnungsabschnitt unmittelbar mit dem Strömungskanal (8) der Abdeckvorrichtung strömungsverbunden ist.

## Claims

1. Cover device (3) for an electronics housing (2) of an electric motor (1) with at least one base segment (4) and several ribs (13) formed on the base segment (4), wherein said base segment (4) is geometrically configured so as to cover at least part of an electronics housing opening for drawing in a cooling air volume flow in order to close the electronics housing opening at least for a portion against the intrusion of solids, and said ribs (13) are formed as axial ribs and respectively form a flow duct (8) with a surface said base segment (4), said flow duct (8) can be fluidically connected to said electronics housing opening, **characterized in that** said cover device (3) is formed annular or partially annular and said several ribs (13) run at a slant radially inward, so that the flow ducts (8) between the ribs (13) taper in the radially inward direction and wherein said cover device is designed as a modular insert for the electronics housing (2).

2. Cover device according claim 1, **characterized in that** it is formed from a base segment (4) and a cover segment (5), wherein said at least one rib (13) extends between said base segment (4) and said cover segment (5) and said flow ducts (8) are formed by said at least one rib (13), said base segment (4) and said cover segment (5).

3. Cover device according to at least one of the previous claims, **characterized in that** at least said base segment (4) is conical in shape.

4. Cover device according to at least one of the previous claims 2 to 4, **characterized in that** said cover segment (5) is arranged with an inward radial offset relative to a radial outer rim of said base segment (4).

5. Cover device according to the previous claim, **characterized in that** said ribs (13) have a radial outer edge, which directly joins a radial outer rim of said base segment (4) and a radial outer rim of said cover segment (5).

6. Cover device according to the previous claim, **characterized in that** said at least one rib (13) is flush with said radial outer rim of said base segment (4) and/or flush with said radial outer rim of said cover segment (5).

7. Cover device according to at least one of the previous claims 2 to 7, **characterized in that** said ribs (13) extend radially inward in the radial direction beyond a radial inner rim of said cover segment (5).

8. Use of a cover device (3) according to at least one of the previous claims, on an electronics housing (2) of an electric motor (1).

9. Electric motor, comprising an electronics housing (2) with motor electronics housed therein, wherein said electronics housing (2) has an integrated cooling air duct (6) extending at least in the axial direction past said motor electronics, through which cooling air duct (6) the cooling air volume flow can be delivered, wherein said cooling air duct (6) ends at the electronics housing opening, **characterized in that** said cover device (3) according to at least one of the claims 1 to 7 can be fastened on said electronics housing opening.

10. Electric motor according to the previous claim, **characterized in that** said electronics housing opening is formed by cooling ribs (12) and said ribs (13) of the cover device (3) extend parallel and/or in radial prolongation to said cooling ribs (12) of said electronics housing (2).

11. Electric motor according to the previous claim, **characterized in that** said electronics housing opening has a radial opening segment, which is oriented perpendicular to an axis of rotation of said electric motor, wherein the radial opening segment is fluidically connected directly to said flow duct (8) of said cover device.

## Revendications

1. Dispositif de recouvrement (3) pour un boîtier électronique (2) d'un moteur électrique (1), comprenant au moins un segment de base (4) et plusieurs nervures (13) réalisées sur le segment de base (4), le segment de base (4) étant réalisé de manière géométrique pour recouvrir au moins par endroits une ouverture de boîtier électronique servant à aspirer un débit volumique d'air de refroidissement afin de fermer l'ouverture de boîtier électronique au moins partiellement contre la pénétration de matières solides, et les nervures (13) étant réalisées sous forme de nervures axiales et formant avec une surface du segment de base (4) respectivement un passage d'écoulement (8) qui peut être mis en communication d'écoulement avec l'ouverture de boîtier électronique,
**caractérisé en ce que** le dispositif de recouvrement est réalisé en forme d'anneau ou d'anneau partiel, et les plusieurs nervures (13) s'étendent en oblique radialement vers l'intérieur de sorte que les passages d'écoulement (8) entre les nervures (13) se rétrécissent dans la direction radialement vers l'intérieur, et le dispositif de recouvrement étant réalisé sous forme d'insert modulaire pour le boîtier électronique (2).

2. Dispositif de recouvrement selon la revendication 1, **caractérisé en ce qu'**il est réalisé à partir d'un segment de base (4) et d'un segment couvrant (5), ladite au moins une nervure (13) s'étendant entre le segment de base (4) et le segment couvrant (5), et ladite au moins une nervure (13), le segment de base (4) et le segment couvrant (5) formant les passages d'écoulement (8).

3. Dispositif de recouvrement selon au moins l'une des revendications précédentes, **caractérisé en ce qu'**au moins le segment de base (4) est réalisé de manière conique.

4. Dispositif de recouvrement selon au moins l'une des revendications précédentes 2 à 4, **caractérisé en ce que** le segment couvrant (5) est disposé de manière décalée radialement vers l'intérieur par rapport à un bord extérieur radial du segment de base (4).

5. Dispositif de recouvrement selon la revendication précédente, **caractérisé en ce que** les nervures (13) présentent une arête extérieure radiale qui relie directement un bord extérieur radial du segment de base (4) et un bord extérieur radial du segment couvrant (5).

6. Dispositif de recouvrement selon la revendication précédente, **caractérisé en ce que** les nervures (13) se terminent en affleurement avec le bord extérieur radial du segment de base (4) et/ou en affleurement avec le bord extérieur radial du segment couvrant (5).

7. Dispositif de recouvrement selon au moins l'une des revendications précédentes 2 à 7, **caractérisé en ce que** les nervures (13) s'étendent radialement vers l'intérieur dans la direction radiale au-delà d'un bord intérieur radial du segment couvrant (5).

8. Utilisation d'un dispositif de recouvrement (3) selon au moins l'une des revendications précédentes sur un boîtier électronique (2) d'un moteur électrique (1).

9. Moteur électrique, comprenant un boîtier électronique (2) avec une électronique de moteur reçue dans celui-ci, le boîtier électronique (2) présentant un passage d'air de refroidissement (6) intégré qui s'étend au moins dans la direction axiale en passant devant l'électronique de moteur et qui permet d'acheminer le débit volumique d'air de refroidissement, le passage d'air de refroidissement (6) se terminant au niveau de l'ouverture de boîtier électronique, **caractérisé en ce que** le dispositif de recouvrement (3) selon au moins l'une des revendications 1 à 7 peut être fixé sur l'ouverture de boîtier électronique.

10. Moteur électrique selon la revendication précédente, **caractérisé en ce que** l'ouverture de boîtier électronique est formée par des nervures de refroidissement (12) et les nervures (13) du dispositif de recouvrement (3) s'étendent en parallèle et/ou en prolongement radial des nervures de refroidissement (12) du boîtier électronique (2).

11. Moteur électrique selon la revendication précédente, **caractérisé en ce que** l'ouverture de boîtier électronique présente une section d'ouverture radiale qui est orientée perpendiculairement à un axe de rotation du moteur électrique, la section d'ouverture radiale étant en communication d'écoulement directe avec le passage d'écoulement (8) du dispositif de recouvrement.
